# EUROPÄISCHE PATENTSCHRIFT

(11) **EP 3 308 615 B1**
(45) Veröffentlichungstag und Bekanntmachung des Hinweises auf die Patenterteilung: **13.05.2020**
(21) Anmeldenummer: 16728605.3
(22) Anmeldetag: 02.06.2016
(51) Int. Cl.: H05K 13/04, H05K 13/08

(54) **VERFAHREN ZUR POSITIONSGENAUEN BESTÜCKUNG EINES SCHALTUNGSTRÄGERS**
METHOD FOR ACCURATELY POPULATING A CIRCUIT CARRIER
PROCÉDÉ PERMETTANT D'ÉQUIPER UN SUPPORT DE CIRCUIT DANS UNE POSITION PRÉCISE

(30) Priorität: 09.06.2015 AT 504692015
(43) Veröffentlichungstag der Anmeldung: 18.04.2018
(73) Patentinhaber: ZKW Group GmbH, 3250 Wieselburg (AT)
(72) Erfinder: ZORN, Jürgen, 3511 Oberfucha (AT); KIESLINGER, Dietmar, 2604 Theresienfe (AT)
(74) Vertreter: Patentanwaltskanzlei Matschnig & Forsthuber OG
(86) Internationale Anmeldenummer: PCT/AT2016/050173
(87) Internationale Veröffentlichungsnummer: WO 2016/197166

(56) Entgegenhaltungen:
- EP-A1- 1 872 624
- EP-A1- 2 807 905
- EP-A2- 2 327 582
- US-A- 5 173 759

## Beschreibung

Die Erfindung betrifft ein Verfahren zur positionsgenauen Bestückung eines Schaltungsträgers mit zumindest einer elektronischen Komponente, welche zumindest zwei getrennt voneinander ansteuerbare lichtemittierende Flächen umfasst.

Des Weiteren betrifft die Erfindung einen Schaltungsträger mit zumindest einer elektronischen Komponente, wobei die elektronische Komponente zumindest zwei getrennt voneinander ansteuerbare lichtemittierende Flächen aufweist. Ferner betrifft die Erfindung einen Kraftfahrzeugscheinwerfer mit einem erfindungsgemäßen Schaltungsträger.

Aus dem Stand der Technik sind Verfahren zur positionsgenauen Bestückung eines Schaltungsträgers mit elektronischen Komponenten bekannt geworden, die jeweils genau eine lichtemittierende Fläche aufweisen.

Hierzu zeigt beispielsweise die US 5 173 759 A zumindest einen Array mit lichtemittierenden Komponenten, die mehrere lichtemittierende Bereiche, welche in gleichbleibenden Abständen zueinander entlang einer vordefinierten Anordnungsrichtung angeordnet sind, und Referenzbereiche aufweist, welche die gleiche Zusammensetzung wie die lichtemittierenden Bereiche besitzen und ebenfalls eine vordefinierte Positionen bezüglich der lichtemittierenden Bereiche aufweisen, wobei die Referenzbereiche eine Basis zur Bestimmung einer Distanz zwischen benachbarten Arrays mit lichtemittierenden Komponenten vorsehen.

Die EP 1 872 624 A1 zeigt ein LED-Modul mit mindestens einem LED-Array aus mehreren LED-Chips und mindestens einer Steuereinheit zur Regelung eines Betriebsstroms der LED-Chips, wobei die mindestens eine Steuereinheit auf einem Träger des LED-Moduls angeordnet ist und ein elektronisches Speichermedium zur Speicherung von Betriebsdaten der LED-Chips aufweist, und eine Regelung des Betriebsstroms vorgesehen ist.

Die EP 2 327 582 A2 zeigt ein LED-Paket, welches ein Paket-Substrat, eine Leuchtdiode, die auf einer Seite des Substrats angeordnet ist, eine Elektrode, welche auf einer anderen Seite des Substrats angeordnet ist und eine elektrische Verbindung zu der Leuchtdiode aufweist, und ein Wärmestrahlungskissen umfasst, das auf der anderen Seite des Substrats angeordnet ist und von der Elektrode elektrisch isoliert ist.

Die EP 2 807 905 A1 zeigt ein Verfahren, bei dem elektronische Komponenten mit einer einzelnen lichtemittierenden Fläche positioniert werden.

Diverse Entwicklungen in der Lichttechnologie haben es nunmehr ermöglicht, elektronische Komponenten mit zumindest zwei getrennt voneinander ansteuerbaren lichtemittierenden Flächen auszustatten. Bei einer solchen Komponente kann es sich beispielsweise um die unter der Bezeichnung "OSLON Black Flat" (Modell KW H3L531.TE) gehandelte LED-Lichtquelle des Herstellers OSRAM handeln. Damit kann die Anzahl der an einem Schaltungsträger anzuordnenden elektronischen Komponenten bedeutend reduziert werden, die beispielsweise für den Einsatz in einem LED-Matrixscheinwerfer vorgesehen sein können.

Durch das Vorhandensein zumindest zweier getrennt voneinander ansteuerbarer lichtemittierenden Flächen an einer einzigen elektronischen Komponente besteht bei der Montage solcher Elemente bei der Anwendung bisher bekannter Verfahren das Problem, dass eine Vorbedingung dieser Verfahren - nämlich dass jede elektronische Komponente genau eine lichtemittierende Fläche aufweist - nicht erfüllt ist. Um die besagten Verfahren einzusetzen, müsste daher zuerst eine der zumindest zwei lichtemittierenden Flächen nach festzulegenden bisher unbekannten Kriterien ausgewählt werden. In diesen Fall blieben allerdings die verbleibenden lichtemittierenden Flächen unberücksichtigt. Wird ein Schaltungsträger daher mit elektronischen Komponenten aufweisend zumindest zwei lichtemittierende Flächen in herkömmlicher Weise bestückt, so kann eine optimale Ausrichtung der Komponenten bzw. der lichtemittierenden Flächen nicht gewährleistet werden. Fehler in der Ausrichtung/Position der lichtemittierenden Flächen können allerdings insbesondere bei einem Einsatz in einem Kraftfahrzeugscheinwerfer zu unzulässigen Ungenauigkeiten und Abbildungsfehlern im Lichtbild des Kraftfahrzeugscheinwerfers führen.

Eine Aufgabe der Erfindung besteht daher darin, ein Verfahren zur positionsgenauen Bestückung eines Schaltungsträgers mit zumindest einer elektronischen Komponente zu schaffen, welche zumindest zwei getrennt voneinander ansteuerbare lichtemittierende Flächen umfasst.

Diese Aufgabe wird mit einem Verfahren der eingangs genannten Art gelöst, welches erfindungsgemäß die folgenden Schritte aufweist:
a) Optisches Erfassen von Ist-Positionen der zumindest zwei lichtemittierenden Flächen der elektronischen Komponente,
b) Berechnen zumindest einer die geometrische Lage der lichtemittierenden Flächen charakterisierenden Ist-Größe in Abhängigkeit der Ist-Positionen der zumindest zwei lichtemittierenden Flächen der elektronischen Komponente,
c) Vergleich der zumindest einen Ist-Größe mit zumindest einer Sollgröße zur Berechnung zumindest einer Korrekturgröße,
d) Bestücken des Schaltungsträgers mit der zumindest einen elektronischen Komponente in Abhängigkeit von der zumindest einen Korrekturgröße.

Dank der Erfindung ist es möglich, eine positionsgenaue Bestückung eines Schaltungsträgers mit zumindest einer elektronischen Komponente, welche zumindest zwei getrennt voneinander ansteuerbare lichtemittierende Flächen umfasst, zu realisieren, bei der Positionsfehler von zwei oder mehr lichtemittierenden Flächen an der elektronischen Komponente erfasst und durch Berechnung einer Korrekturgröße kompensiert werden können.

Das optische Erfassen der Ist-Positionen der elektronischen Komponente erfolgt typischerweise unter Verwendung eines Kamerasystems sowie geeigneter Bildverarbeitungsalgorithmen, wobei die Positionen unter Bezugnahme zu einem Referenzpunkt erfasst werden, der beispielsweise an der elektronischen Komponente oder an dem Schaltungsträger ausgebildet sein kann. Unter dem Ausdruck "(Ist-)Position einer Fläche" wird dabei nicht nur die Abmessung der Fläche sondern auch Ihre Lage bzw. räumliche Orientierung in Bezug zu dem Referenzpunkt verstanden.

Bei der Sollgröße handelt es sich um vordefinierte Werte bezüglich Lage und Orientierung der lichtemittierenden Flächen in Bezug auf den Referenzpunkt. Die Sollgröße wird beispielsweise aus der geometrischen Sollposition und Sollabmessung der lichtemittierenden Flächen in Bezug zu dem Referenzpunkt ermittelt, die beispielsweise aus einem Datenblatt vorbekannt sind oder berechnet werden können. Näheres hierzu folgt in der Figurenbeschreibung.

Die Bestückung unter Punkt d) des Verfahrens erfolgt insofern unter Berücksichtigung der Korrekturgröße, als dass eine vordefinierte Einbauposition unter Zuhilfenahme der Korrekturgröße zu einer tatsächlichen Einbauposition korrigiert wird, in der die elektronische Komponente auf den Schaltungsträger aufgebracht, insbesondere mit diesem verlötet wird. Die Korrekturgröße wird mittels einer digitalen Recheneinheit ermittelt und kann in digitaler Form an eine Bestückungseinrichtung übergeben werden.

So kann es vorgesehen sein, dass die die geometrische Lage der lichtemittierenden Flächen charakterisierende Ist-Größe und die Sollgröße einer digitalen Recheneinheit zugeführt oder durch diese erfasst werden, in der die Korrekturgröße berechnet wird, wobei die Korrekturgröße als digitales Informationssignal an eine Bestückungseinrichtung zur Bestückung gemäß Schritt d) übergeben wird.

Vorzugsweise kann vorgesehen sein, dass die Korrekturgröße zumindest eine Vektorgröße umfasst, wobei die Richtung der Vektorgröße parallel zur Bestückungsfläche des Schaltungsträgers orientiert ist. In einem kartesischen Koordinatensystem bestehend aus den zueinander orthogonalen Achsen x, y und z, in welchem die Achsen x und y parallel zur Bestückungsfläche des Schaltungsträgers orientiert sind, enthält die Vektorgröße daher Angaben zu Betrag und Richtung eines Vektors in der x-y-Ebene. Die Bestückung kann damit in x- und y-Richtung korrigiert werden.

Außerdem kann es günstig sein, wenn die Korrekturgröße eine Winkelangabe zur Drehung um eine Drehachse z umfasst, wobei die Drehachse z orthogonal zur Bestückungsfläche des Schaltungsträgers orientiert ist. Dadurch ist es möglich, die Orientierung der elektronischen Komponente an dem Schaltungsträger zu verändern. Als Voraussetzung hierfür ist es natürlich vorgesehen, dass die Sollgröße Informationen zu einer Sollorientierung der elektronischen Komponente enthält, sodass durch einen Vergleich der Ist-Größe mit der Sollgröße die Korrekturgröße errechnet werden kann.

Um die Orientierung der lichtemittierenden Flächen in einfacher Weise zu erfassen, kann es vorgesehen sein, dass die zumindest eine Ist-Größe eine den Verlauf, insbesondere die Neigung, der sichtbaren Kanten der lichtemittierenden Flächen charakterisierende Information umfasst. Diese Information kann beispielsweise die Position mehrerer Punkte der Kante umfassen, die beispielsweise durch eine übliche Kantendetektion (z.B. durch Gradientenfilterung) erfasst werden. Die Lage der Kanten ist insbesondere bei Einsatz in Beleuchtungssystemen von Bedeutung, in denen der Verlauf der Kanten direkten Einfluss auf das Lichtbild des Beleuchtungssystems hat. Dies ist z.B. bei einem Kraftfahrzeugschweinwerfer mit Abblendlichtfunktion der Fall, bei dem keine zusätzliche Blende zur Festlegung einer Hell-Dunkel-Grenze vorgesehen ist, sondern die Hell-Dunkel-Grenze beispielsweise durch die Lage der lichtemittierenden Flächen in Bezug zu einem optischen System, beispielsweise einem Reflektor, festgelegt wird. Weitere Lichtfunktionen, bei denen definierte Hell-Dunkel-Übergänge von Bedeutung sind, wären beispielsweise eine Abbiegelichtfunktion, eine Nebellichtfunktion sowie ein adaptives Fernlicht.

Alternativ dazu kann vorgesehen sein, dass die zumindest eine Ist-Größe eine einen virtuellen Schwerpunkt der lichtemittierenden Flächen charakterisierende Information umfasst, wobei der virtuelle Schwerpunkt durch Ermittlung der geometrischen Schwerpunkte der einzelnen lichtemittierenden Flächen unter Berücksichtigung ihrer Ist-Positionen ermittelt wird.

In einer weiteren Variante der Erfindung kann vorgesehen sein, dass die zumindest eine Ist-Größe eine die Abmessungen und Position einer fiktiven Rechteckfläche charakterisierende Information umfasst, wobei die Abmessungen sowie die Position und Orientierung des fiktiven Rechteckes so gewählt wird, dass das Verhältnis aus Überdeckung und Größe der Fläche optimiert ist.

Diese beiden letztgenannten Informationen zur Ist-Größe sind gut geeignet, um bei der Bestückung von Schaltungsträgern eingesetzt zu werden, die zur Erzeugung einer Fernlichtverteilung eingerichtet sind. Dabei ist nämlich weniger der Verlauf einzelner Kanten sondern vielmehr die Homogenität des Gesamtlichtbildes von besonderer Bedeutung, wobei die Lichtbilder einzelner lichtemittierender Flächen typischerweise einander zumindest teilweise überlagert werden, wodurch der Verlauf der einzelnen Kanten weniger wichtig ist. Auch sind diese Methoden gut für die Bestückung von Schaltungsträgern geeignet, die in Abbildungssysteme verbaut werden, bei denen Hell-Dunkel-Grenzen durch zusätzliche Hilfsmittel, wie beispielsweise Blenden, geformt werden.

Insbesondere kann vorgesehen sein, dass die Sollgröße eine Positionsangabe in Bezug zu einem Referenzpunkt umfasst, wobei der Referenzpunkt an der elektronischen Komponente oder dem Schaltungsträger der elektronischen Komponente angeordnet ist. Das optische Erfassen der Ist-Positionen der lichtemittierenden Flächen beinhaltet hierbei zudem ein Erfassen der Referenzpunkte, sodass die Positionen in Bezug auf die Referenzpunkte gemessen werden können.

In einer günstigen Ausführung der Erfindung können die lichtemittierenden Flächen voneinander beabstandet sein. Alternativ dazu könnten die lichtemittierenden Flächen an einer einzigen Konverterfläche angeordnet sein, wobei unterschiedliche Bereiche der Konverterfläche durch voneinander getrennt ansteuerbare Chips angesteuert und aktiviert werden können.

Insbesondere kann vorgesehen sein, dass die zumindest eine elektronische Komponente eine Mehrzahl von zumindest drei, vier oder fünf lichtemittierenden Flächen aufweist, die vorzugsweise in einer Reihe angeordnet sind.

Besonders günstig kann es sein, wenn die elektronische Komponente eine LED, vorzugsweise eine SMD-LED ist.

Um die lichtemittierenden Flächen einfacher optisch erfassen zu können, kann es günstig sein, die lichtemittierenden Flächen während des Schrittes a) durch eine externe Lichtquelle zu beleuchten.

Insbesondere können die lichtemittierenden Flächen während des Schrittes a) zur Emission von Licht angeregt werden. Die Anregung kann entweder durch Anleuchten in ausreichender Intensität durch eine externe Lichtquelle oder auch durch Aktivierung der elektronischen Komponente erfolgen.

In einem weiteren Aspekt betrifft die Erfindung einen Schaltungsträger mit zumindest einer elektronischen Komponente, wobei die elektronische Komponente zumindest zwei getrennt voneinander ansteuerbare lichtemittierende Flächen aufweist, dadurch gekennzeichnet, dass Bestücken des Schaltungsträgers mit der zumindest einen elektronischen Komponente in Abhängigkeit von den Ist-Positionen der zumindest zwei lichtemittierenden Flächen der elektronischen Komponente nach einem eingangs genannten erfindungsgemäßen Verfahren erfolgt.

Außerdem betrifft die Erfindung einen Kraftfahrzeugscheinwerfer mit einem erfindungsgemäßen Schaltungsträger.

Die Erfindung ist im Folgenden anhand einer beispielhaften und nicht einschränkenden Ausführungsform näher erläutert, die in den Figuren veranschaulicht ist. Darin zeigt
Figur 1 eine schematische Darstellung einer fiktiven elektronischen Komponente auf einem Ausschnitt eines Schaltungsträgers,
Figur 2 eine Darstellung der Rückseite der elektronischen Komponente,
Figur 3a und 3b eine Darstellung einer realen elektronischen Komponente mit fehlerhaft angeordneten lichtemittierenden Flächen und sowie eine Maßnahme, dem Fehler entgegen zu wirken,
Figur 4a und 4b eine Darstellung der elektronischen Komponenten gemäß Fig. 3a sowie eine weitere Maßnahme, dem Fehler entgegen zu wirken,
Figur 5 eine weitere elektronische Komponente mit fehlerhaft angeordneten lichtemittierenden Flächen sowie eine weitere Maßnahme, dem Fehler entgegen zu wirken, und
Figur 6 die elektronische Komponente gemäß Figur 5 und eine weitere Maßnahme, dem Fehler entgegen zu wirken.

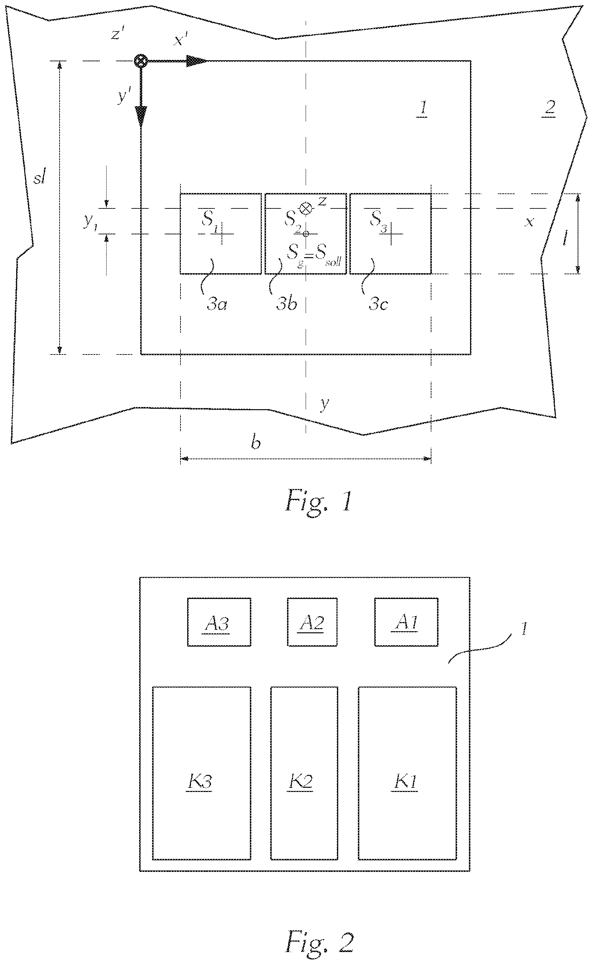

Figur 1 zeigt eine schematische Darstellung einer fiktiven (dem Datenblatt entnommenen) elektronischen Komponente 1 auf einem Ausschnitt eines Schaltungsträgers 2, der mit der elektronischen Komponente 1 (fiktiv) bestückt wurde. Die elektronische Komponente 1 weist in dem vorliegenden Beispiel drei getrennt voneinander ansteuerbare lichtemittierende Flächen 3a, 3b und 3c auf. Aus diesem fiktiven Beispiel kann vorab eine Sollgröße bestimmt werden, mit der die optisch ermittelte Ist-Größe während des tatsächlichen Bestückungsvorganges abgeglichen werden kann.

Einzelne Positionsangaben beziehen sich auf das kartesische Koordinatensystem, bestehend aus den Achsen x, y und z, wobei die Achsen x und y parallel zur Ebene der lichtemittierenden Flächen orientiert sind und die Achse z in die Blattebene ragt. Die Wahl des Koordinatensystems und seiner Lage kann von einem Fachmann frei bestimmt werden, solange eine eindeutige Festlegung der Lage der lichtemittierenden Flächen 3a, 3b und 3c möglich ist. So könnte ebenso ein kartesisches Koordinatensystem x', y', z' herangezogen werden, dessen Ursprung in einer Ecke des Gehäuses der elektronischen Komponente 1 liegt. Solche Ecken können häufig besonders einfach durch optische Detektionsverfahren und nachgeschaltete Bildverarbeitungsalgorithmen erkannt werden. Der Ursprung des gewählten Koordinatensystems bildet den Referenzpunkt für Positionsangaben.

Die lichtemittierenden Flächen 3a, 3b und 3c weisen in dem gezeigten Ausführungsbeispiel eine quadratische Form mit der Seitenlänge l auf. Sie sind in einer Reihe angeordnet und zueinander beabstandet. Bei der beispielhaft dargestellten elektronischen Komponente 1 handelt es sich um das eingangs erwähnte Modell der Serie "OSLON Black Flat", wobei das Gehäuse der elektronischen Komponente eine Seitenlänge sl in x- und y- Richtung zwischen 2 und 10 mm aufweist und die Breite b der Reihe der lichtemittierenden Flächen 3a, 3b und 3c ca. zwischen 1,5 und 9 mm beträgt.

Die lichtemittierenden Flächen 3a, 3b und 3c weisen jeweils Mittelpunkte bzw. Schwerpunkte S₁, S₂ und S₃ auf, wobei diese in Bezug zum Nullpunkt des Koordinatensystems x, y, z versetzt sind. So weisen alle drei Schwerpunkte S₁, S₂ und S₃ einen Versatz y1 (beispielsweise zwischen 0,1 und 0,6 mm, diese Werte werden dem Datenblatt entnommen) in Richtung der y-Achse auf. Die Schwerpunkte S₁ und S₃ sind zudem entgegen/in x-Richtung relativ zu dem Nullpunkt des Koordinatensystems x, y und z verschoben. Aus der Lage der einzelnen lichtemittierenden Flächen 3a, 3b und 3c und/oder den Schwerpunkten S₁, S₂ und S₃ lässt sich ein Gesamtschwerpunkt S_{g} (in den Ansprüchen auch als virtueller Schwerpunkt bezeichnet) berechnen, der - da die Daten der gezeigten elektronischen Komponente 1 den Sollwerten (ohne Toleranz) entsprechen - mit dem Sollschwerpunkt Sₛₒₗₗ zusammenfällt. Dieser Sollschwerpunkt Sₛₒₗₗ kann als Sollgröße im erfindungsgemäßen Verfahren herangezogen werden.

Figur 2 zeigt eine Darstellung der Rückseite der elektronischen Komponente 1, wobei darin die Kontaktflächen der Anoden A1 bis A3 und der Kathoden K1 bis K3 dargestellt sind, die einzelnen Chips, vorzugsweise LED-Chips, zugeordnet sind, die zur Ansteuerung der lichtemittierenden Flächen 3a, 3b und 3c eingerichtet sind. Nach der Bestückung des Schaltungsträgers 2 mit der elektronischen Komponente 1 muss ein ausreichender Kontakt der Kathoden- und Anodenflächen mit korrespondierenden Flächen an dem Schaltungsträger hergestellt werden. Hierzu können die Kontaktflächen beispielsweise mit Lötpaste beschichtet, insbesondere bedruckt sein, und in einem Reflow-Lötverfahren fest mit der elektronischen Komponente 1 verbunden werden.

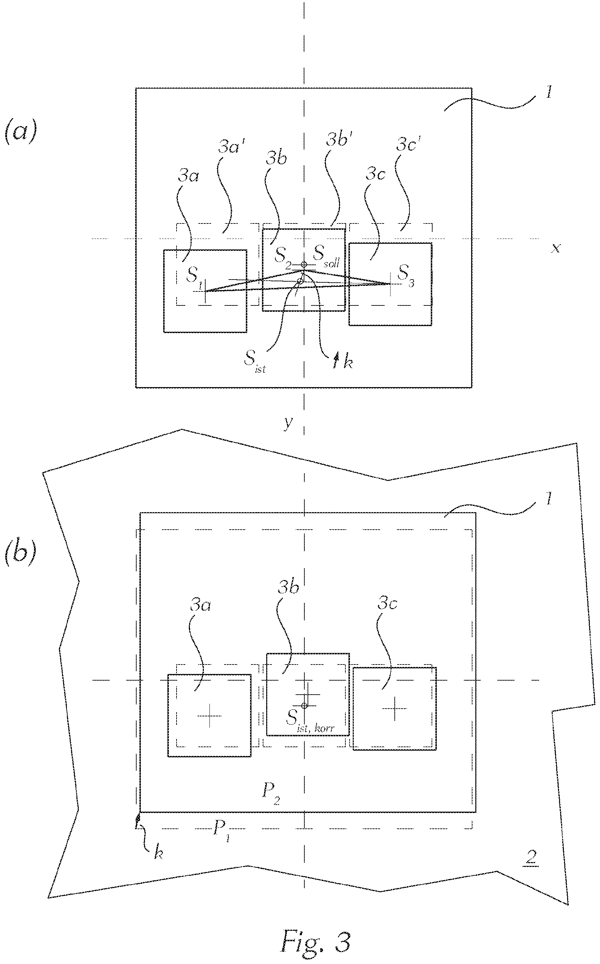

Figur 3a und 3b zeigt eine Darstellung einer realen elektronischen Komponente 1, bei der die lichtemittierenden Flächen 3a, 3b und 3c nicht in den aus dem Datenblatt entnommenen Sollpositionen (durch strichlierte Flächen 3a', 3b' und 3c' angedeutet) angeordnet sind, sondern Abweichungen hierzu aufweisen. Sämtliche der lichtemittierenden Flächen 3a, 3b, 3c weisen einen Versatz in Richtung der y-Achse auf. Die erste lichtemittierende Fläche 3a ist zudem entgegen der Richtung der x-Achse nach außen versetzt. Die einzelnen Schwerpunkte S₁, S₂ und S₃ der lichtemittierenden Flächen 3a, 3b und 3c sind im Gegensatz zur elektronischen Komponente 1 gemäß Datenblatt (siehe Figur 1) nicht mehr auf einer gemeinsamen Linie angeordnet. Figur 3a zeigt nunmehr eine Möglichkeit, eine den versetzten lichtemittierenden Flächen 3a, 3b und 3c zugehörige Ist-Größe (in diesem Beispiel eine Position) zu ermitteln, die mit einer Sollgröße Sₛₒₗₗ, nämliche der gewünschten Lage des Gesamtschwerpunktes, verglichen werden kann.

Zu diesem Zweck wird eine in sich geschlossene geometrische Form festgelegt, deren Eckpunkte durch die Schwerpunkte der einzelnen lichtemittierenden Flächen ausgebildet werden. In diesem Beispiel bilden die Schwerpunkte S₁, S₂, und S₃ ein Dreieck, welches schematisch dargestellt ist. Der Schwerpunkt dieses Dreiecks kann entweder geometrisch durch die in der Figur 3a angedeuteten Schwerlinien oder auch mathematisch ermittelt werden und entspricht dem Gesamtschwerpunkt der lichtemittierenden Flächen 3a, 3b und 3c und kann als Ist-Größe Sᵢₛₜ herangezogen werden. Entsprechend dem Schritt c) des erfindungsgemäßen Verfahrens kann nunmehr die Ist-Größe Sᵢₛₜ mit der Sollgröße Sₛₒₗₗ verglichen werden, um daraus eine Korrekturgröße k zu ermitteln. In diesem Beispiel enthält die Sollgröße Koordinaten zur x- und y- Position des gesamten Sollschwerpunktes und die Ist-Größe Koordinaten zur x- und y- Position des gesamten Istschwerpunktes. Durch Differenzbildung der Koordinaten von Sₛₒₗₗ und Sᵢₛₜ kann die Korrekturgröße k in Form eines Vektors errechnet werden, der zur Korrektur der Bestückungsposition der elektronischen Komponente 1 an dem Schaltungsträger 2 herangezogen werden kann.

Dieser Vorgang ist beispielhaft in Figur 3b dargestellt, in der eine vordefinierte Bestückungsposition Position P1 hin zu einer tatsächlichen Bestückungsposition P2 durch Verschiebung der elektronischen Komponente um den Vektor der Korrekturgröße k korrigiert wurde, sodass die Position von dem korrigierten Gesamtschwerpunkt S_{ist,korr} mit der Position Sₛₒₗₗ übereinstimmt. Dieser Vorgang entspricht dem Schritt d) des erfindungsgemäßen Verfahrens.

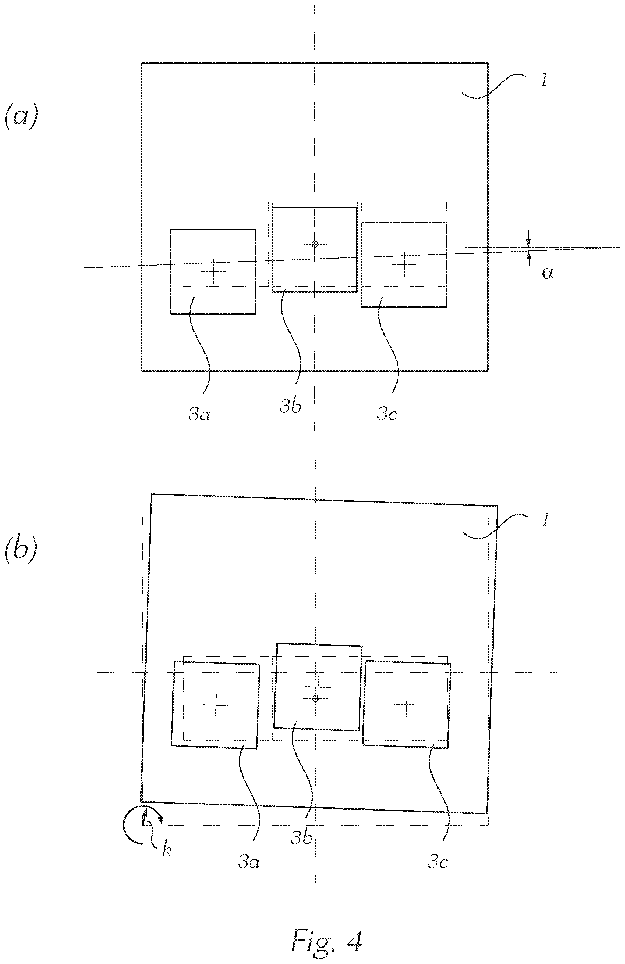

Die Beispiele gemäß den Figuren 4a, 4b, 5 und 6 beschäftigen sich mit anderen, gegebenenfalls alternativen Aspekten der Erfindung und verdeutlichen, dass das erfindungsgemäße Verfahren weitläufig anwendbar und nicht auf die Variante gemäß der Figur 3a und 3b beschränkt ist.

So zeigt Figur 4a die elektronische Komponente 1 gemäß Fig. 3a, wobei eine andere Möglichkeit zur Korrektur der Lage der lichtemittierenden Flächen 3a, 3b und 3c dargestellt ist. Hierbei wird eine Ausgleichsgerade zwischen die einzelnen Schwerpunkte S₁, S₂, und S₃ gelegt, wobei die Neigung α der Ausgleichsgerade in Bezug zur x-Achse (oder y-Achse) festgestellt wird und die Position der elektronischen Komponente 1 gemäß Fig. 4b durch Verschiebung der elektronischen Komponente 1 gemäß Fig. 3b und zusätzlich durch Verdrehen um die z-Achse um den Winkel α korrigiert wird. Die Korrekturgröße k umfasst daher in diesem Beispiel sowohl eine Vektorgröße, die die Koordinaten der Verschiebung in x- und y- Richtung umfasst, als auch eine Winkelangabe, nämlich den Winkel a, der eine Drehung um die Achse z angibt.

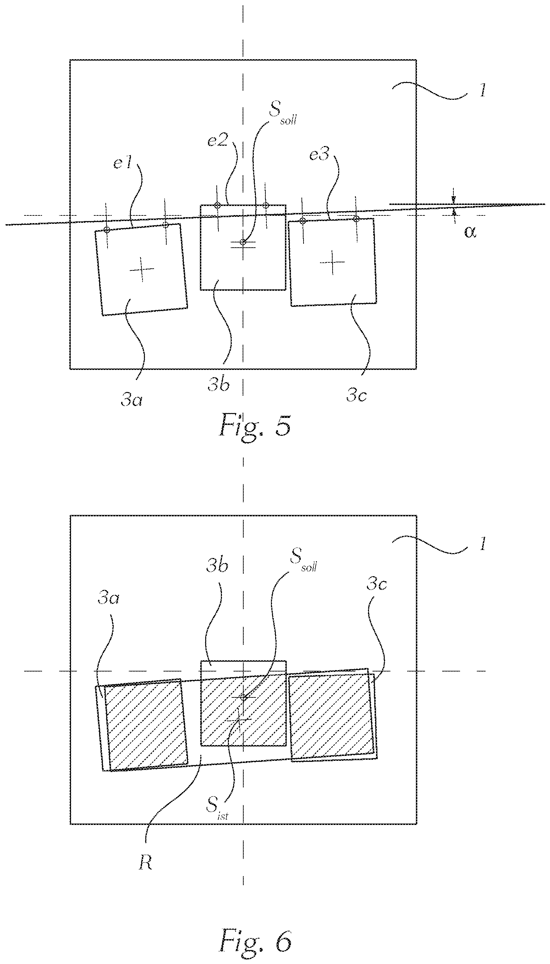

Figur 5 zeigt eine weitere reale elektronische Komponente 1 mit fehlerhaft angeordneten lichtemittierenden Flächen 3a, 3b und 3c sowie eine weitere Maßnahme, dem Fehler entgegen zu wirken. Dabei werden Kanten e1, e2 und e3 der lichtemittierenden Flächen 3a, 3b und 3c optisch erfasst, wobei hierfür die Lage zumindest zweier Punkte der Kanten e1, e2 und e3 festgestellt werden muss. Die Lage und der Verlauf der Kanten kann gemittelt werden, sodass ähnlich zu dem Verfahren gemäß Figur 4a und 4b eine Ausgleichsgerade berechnet werden kann, deren Neigung α zur Korrektur der tatsächlichen Bestückungsposition der elektronischen Komponente 1 herangezogen werden kann. Die Korrektur der Orientierung der Kanten e1, e2 und e3 der lichtemittierenden Flächen 3a, 3b und 3c ist vor allem für Kraftfahrzeugscheinwerfermodule von Bedeutung, bei welchen die einzelnen Lichtquellen scharf im Lichtbild des Scheinwerfers abgebildet werden, wie dies beispielsweise für die Einhaltung von Helldunkelgrenzen bei Abblendlicht, adaptivem Fernlicht, Abbiegelicht- und Nebellichtmodulen der Fall ist, bei denen die Abblendlichtverteilung durch die Lage der Lichtquellen in Bezug zu sowie in Zusammenhang mit einem Reflektor festgelegt wird.

Figur 6 zeigt zu der elektronischen Komponente 1 gemäß Figur 5 eine weitere Maßnahme, der fehlerhaften Position der lichtemittierenden Flächen 3a, 3b und 3c entgegen zu wirken. Hierfür umfasst die Ist-Größe Sᵢₛₜ eine die Abmessungen und Position einer fiktiven Rechteckfläche R charakterisierende Information, wobei die Abmessungen sowie die Position und Orientierung des fiktiven Rechteckes R so gewählt wird, dass das Verhältnis aus Überdeckung und Größe der Fläche optimiert ist. In einer einfachsten Variante diese Verfahrens kann es vorgesehen sein, dass das Rechteck R anhand der Positionen und Abmessungen der lichtemittierenden Flächen 3a, 3b und 3c der elektronischen Komponente 1 gemäß Fig. 1 bestimmt wird und das so erhaltene Rechteck R so positioniert und orientiert wird, dass die Flächenüberdeckung mit den lichtemittierenden Flächen 3a, 3b und 3c ein Maximum annimmt. Die Lage des Schwerpunktes sowie die Orientierung des Rechtecks R kann wiederum zur Korrektur der Bestückungsposition der elektronischen Komponente 1 herangezogen werden.

Der im Rahmen der Patentansprüche häufig gebrauchte Ausdruck "charakterisierende Information" bedeutet lediglich, dass geeignete Größen oder Felder zur Kennzeichnung der betreffenden Information herangezogen werden, die zur Wiedergabe und eindeutigen Festlegung der betreffenden Information geeignet sind. Die Position und Orientierung der fiktiven Rechteckfläche R charakterisierende Information kann zum Beispiel durch ein Feld gegeben sein, in welchem Einträge zu Länge, Breite, Position und Orientierung des Rechtecks R angegeben sind.

Die Verbesserung der Lage des Gesamtschwerpunktes S_{g} der lichtemittierenden Flächen 3a, 3b und 3c ist insbesondere für Fernlichtfunktionen bzw. für alle weiteren Funktionen von Bedeutung, bei denen Hell-Dunkel-Grenzen mittels zusätzlicher Hilfselemente wie beispielsweise Blenden festgelegt werden.

Die in den Figuren 1 bis 6 gezeigten Ausführungsbeispiele offenbaren eine elektronische Komponente 1 mit drei lichtemittierenden Flächen 3a, 3b und 3c. Die Anzahl der lichtemittierenden Flächen kann natürlich von der gezeigten Anzahl abweichen. Ebenso kann die geometrische Form der lichtemittierenden Flächen von den gezeigten Formen abweichen.

Zur einfacheren Erkennung der lichtemittierenden Flächen 3a, 3b und 3c kann es vorgesehen sein, dass diese während des Schrittes a) durch eine externe Lichtquelle beleuchtet werden, wodurch der Kontrast der lichtemittierenden Flächen 3a, 3b und 3c zu umgebenden Flächen verbessert werden kann. Diese externe Lichtquelle strahlt vorzugsweise blaues Licht auf die lichtemittierenden Flächen 3a, 3b und 3c. Abhängig davon, ob eine rasche optische Erfassung wesentlich ist (beispielsweise für eine rasche Bestückung), kann es vorgesehen sein, dass die Wellenlänge sowie die Intensität des von der externen Lichtquelle abgestrahlten Lichtes so gewählt ist, dass die lichtemittierenden Flächen 3a, 3b und 3c zur Abstrahlung von Licht angeregt werden.

In Anbetracht dieser Lehre ist der Fachmann in der Lage zu anderen, nicht gezeigten Ausführungsformen der Erfindung zu gelangen. Die Erfindung ist daher nicht auf die gezeigten Ausführungsformen beschränkt. Auch können einzelne Aspekte der Erfindung bzw. der Ausführungsformen aufgegriffen und miteinander kombiniert werden. Wesentlich sind die der Erfindung zugrunde liegenden Gedanken, die durch einen Fachmann in Kenntnis dieser Beschreibung in mannigfaltiger Weise ausgeführt werden können und trotzdem als solche aufrechterhalten bleiben.

## Patentansprüche

1. Verfahren zur positionsgenauen Bestückung eines Schaltungsträgers (2) mit zumindest einer elektronischen Komponente (1), welche zumindest zwei getrennt voneinander ansteuerbare lichtemittierende Flächen (3a, 3b, 3c) umfasst, mittels dessen Positionsfehler der lichtemittierenden Flächen (3a, 3b, 3c) an der elektronischen Komponente erfasst und durch Berechnung einer Korrekturgröße (k) kompensiert werden, aufweisend die folgenden Schritte:
a) Optisches Erfassen von Ist-Positionen der zumindest zwei lichtemittierenden Flächen (3a, 3b, 3c) der elektronischen Komponente (1) unter Bezugnahme zu einem Referenzpunkt,
b) Berechnen zumindest einer die geometrische Lage der lichtemittierenden Flächen (3a, 3b, 3c) charakterisierenden Ist-Größe (Sᵢₛₜ) in Abhängigkeit der Ist-Positionen der zumindest zwei lichtemittierenden Flächen (3a, 3b, 3c) der elektronischen Komponente (1),
c) Vergleich der zumindest einen Ist-Größe (Sᵢₛₜ) mit zumindest einer Sollgröße (Sₛₒₗₗ) zur Berechnung zumindest einer Korrekturgröße (k), wobei es sich bei der Sollgröße (Ssoll) um vordefinierte Werte bezüglich Lage und Orientierung der lichtemittierenden Flächen (3a, 3b, 3c) in Bezug auf den Referenzpunkt handelt,
d) Bestücken des Schaltungsträgers (2) mit der zumindest einen elektronischen Komponente (1) in Abhängigkeit von der zumindest einen Korrekturgröße (k).

2. Verfahren nach Anspruch 1, **dadurch gekennzeichnet, dass** die Ist-Größe (Sᵢₛₜ) und die Sollgröße (Sₛₒₗₗ) einer digitalen Recheneinheit zugeführt oder durch diese erfasst wird, in der die Korrekturgröße (k) berechnet wird, wobei die Korrekturgröße (k) als digitales Informationssignal an eine Bestückungseinrichtung zur Bestückung gemäß Schritt d) übergeben werden.

3. Verfahren nach Anspruch 1 oder 2, **dadurch gekennzeichnet, dass** die Korrekturgröße (k) zumindest eine Vektorgröße umfasst, wobei die Richtung der Vektorgröße parallel zur Bestückungsfläche des Schaltungsträgers (2) orientiert ist.

4. Verfahren nach Anspruch 3, **dadurch gekennzeichnet, dass** die Korrekturgröße (k) zudem eine Winkelangabe zur Drehung um eine Drehachse (z) umfasst, wobei die Drehachse orthogonal zur Bestückungsfläche des Schaltungsträgers (2) orientierte ist.

5. Verfahren nach einem der Ansprüche 1 bis 4, **dadurch gekennzeichnet, dass** die zumindest eine Ist-Größe (Sᵢₛₜ) eine den Verlauf, insbesondere die Neigung, der sichtbaren Kanten der lichtemittierenden Flächen (3a, 3b, 3c) charakterisierende Information umfasst.

6. Verfahren nach einem der Ansprüche 1 bis 4, **dadurch gekennzeichnet, dass** die zumindest eine Ist-Größe (Sᵢₛₜ) eine einen virtuellen Schwerpunkt (S_{g}) der lichtemittierenden Flächen (3a, 3b, 3c) charakterisierende Information umfasst, wobei der virtuelle Schwerpunkt (S_{g}) durch Ermittlung der geometrischen Schwerpunkte (S₁, S₂, S₂) der einzelnen lichtemittierenden Flächen (3a, 3b, 3c) unter Berücksichtigung ihrer Ist-Positionen ermittelt wird.

7. Verfahren nach einem der Ansprüche 1 bis 4, **dadurch gekennzeichnet, dass** die zumindest eine Ist-Größe (Sᵢₛₜ) eine die Abmessungen und Position einer fiktiven Rechteckfläche charakterisierende Information umfasst, wobei die Abmessungen sowie die Position und Orientierung des fiktiven Rechteckes (R) so gewählt wird, dass das Verhältnis aus Überdeckung und Größe der Fläche optimiert ist.

8. Verfahren nach einem der Ansprüche 1 bis 7, **dadurch gekennzeichnet, dass** die Sollgröße (Sₛₒₗₗ) eine Positionsangabe in Bezug zu einem Referenzpunkt umfasst, wobei der Referenzpunkt an der elektronischen Komponente (1) oder dem Schaltungsträger (2) der elektronischen Komponente (1) angeordnet ist.

9. Verfahren nach einem der Ansprüche 1 bis 8, **dadurch gekennzeichnet, dass** die lichtemittierenden Flächen (3a, 3b, 3c) voneinander beabstandet sind.

10. Verfahren nach einem der Ansprüche 1 bis 9, **dadurch gekennzeichnet, dass** die zumindest eine elektronische Komponente (1) eine Mehrzahl von zumindest drei, vier oder fünf lichtemittierende Flächen (3a, 3b, 3c) aufweist, die vorzugsweise in einer Reihe angeordnet sind.

11. Verfahren nach einem der Ansprüche 1 bis 10, **dadurch gekennzeichnet, dass** die elektronische Komponente (1) eine LED, vorzugsweise eine SMD-LED ist.

12. Verfahren nach einem der Ansprüche 1 bis 11, **dadurch gekennzeichnet, dass** die lichtemittierenden Flächen (3a, 3b, 3c) während des Schrittes a) durch eine externe Lichtquelle beleuchtet werden.

13. Verfahren nach einem der Ansprüche 1 bis 12, **dadurch gekennzeichnet, dass** die lichtemittierenden Flächen (3a, 3b, 3c) während des Schrittes a) zur Emission von Licht angeregt werden.

## Claims

1. Method for the positionally accurate population of a circuit substrate (2) with at least one electronic component (1), which comprises at least two light-emitting surfaces (3a, 3b, 3c), which can be activated separately from one another, and by means of which positional errors of the light-emitting surfaces (3a, 3b, 3c) on the electronic component are detected, and compensated for by the calculation of a correction variable (k), having the following steps:
a) Optical detection of the actual positions of at least two light-emitting surfaces (3a, 3b, 3c) of the electronic component (1) with respect to a reference point,
b) Calculation of at least one actual variable (Sᵢₛₜ), characterising the geometrical position of the light-emitting surfaces (3a, 3b, 3c) as a function of the actual positions of the at least two light-emitting surfaces (3a, 3b, 3c) of the electronic component (1),
c) Comparison of the at least one actual variable (Sᵢₛₜ) with at least one desired variable (Sₛₒₗₗ), for purposes of calculating at least one correction variable (k), wherein the desired variable (Sₛₒₗₗ) takes the form of predefined values relating to the position and orientation of the light-emitting surfaces (3a, 3b, 3c) with respect to the reference point,
d) Population of the circuit substrate (2) with the at least one electronic component (1) as a function of the at least one correction variable (k).

2. Method according to Claim 1,
**characterised in that**,
the actual variable (Sᵢₛₜ) and the desired variable (Sₛₒₗₗ) are fed to a digital computing unit, or are detected by the latter, in which the correction variable (k) is calculated, wherein
the correction variable (k) is transferred as a digital information signal to a populating device for purposes of population in accordance with step d).

3. Method according to Claim 1 or 2,
**characterised in that**,
the correction variable (k) comprises at least one vector variable, wherein
the direction of the vector variable is oriented parallel to the populated surface of the circuit substrate (2).

4. Method according to Claim 3,
**characterised in that**,
the correction variable (k) also comprises an angular specification for purposes of rotation about an axis of rotation (z), wherein
the axis of rotation is oriented orthogonally with respect to the populated surface of the circuit substrate (2).

5. Method according to one of the Claims 1 to 4, **characterised in that**,
the at least one actual variable (Sᵢₛₜ) comprises information characterising the profile, in particular the inclination, of the visible edges of the light-emitting surfaces (3a, 3b, 3c).

6. Method according to one of the Claims 1 to 4, **characterised in that**,
the at least one actual variable (Sᵢₛₜ) comprises information characterising a virtual centre of gravity (S_{g}) of the light-emitting surfaces (3a, 3b, 3c),
wherein
the virtual centre of gravity (S_{g}) is determined by the determination of the geometrical centres of gravity (S₁, S₂, S₃) of the individual light-emitting surfaces (3a, 3b, 3c), whilst taking into account their actual positions.

7. Method according to one of the Claims 1 to 4, **characterised in that**,
the at least one actual variable (Sᵢₛₜ) comprises information characterising the dimensions and position of a fictitious rectangular surface, wherein
the dimensions, together with the position and orientation of the fictitious rectangle (R), are chosen such that the ratio of overlap and size of the surface is optimised.

8. Method according to one of the Claims 1 to 7, **characterised in that**,
the desired variable (Sₛₒₗₗ) comprises a positional specification with respect to a reference point,
wherein
the reference point is arranged on the electronic component (1), or the circuit substrate (2) of the electronic component (1).

9. Method according to one of the Claims 1 to 8, **characterised in that**,
the light-emitting surfaces (3a, 3b, 3c) are spaced apart from one another.

10. Method according to one of the Claims 1 to 9, **characterised in that**,
the at least one electronic component (1) comprises a multiplicity of at least three, four or five light-emitting surfaces (3a, 3b, 3c), which are preferably arranged in a row.

11. Method according to one of the Claims 1 to 10, **characterised in that**,
the electronic component (1) is an LED, preferably an SMD LED.

12. Method according to one of the Claims 1 to 11, **characterised in that**,
during step a) the light-emitting surfaces (3a, 3b, 3c) are illuminated by an external light source.

13. Method according to one of the Claims 1 to 12, **characterised in that**,
during step a) the light-emitting surfaces (3a, 3b, 3c) are excited so as to emit light.

## Revendications

1. Procédé pour l'équipement à précision de positionnement d'un support de circuit (2) avec au moins un composant électronique (1), lequel comprend au moins deux surfaces d'émission de lumière (3a, 3b, 3c) pouvant être commandées séparément l'une de l'autre, au moyen duquel des erreurs de position des surfaces d'émission de lumière (3a, 3b, 3c) au niveau du composant électronique sont détectées et sont compensées par calcul d'une grandeur de correction (k), présentant les étapes suivantes :
a) la détection optique de positions réelles des au moins deux surfaces d'émission de lumière (3a, 3b, 3c) du composant électronique (1) en tenant compte d'un point de référence,
b) le calcul d'au moins une grandeur réelle (Sᵢₛₜ) caractérisant la position géométrique des surfaces d'émission de lumière (3a, 3b, 3c) en fonction des positions réelles des au moins deux surfaces d'émission de lumière (3a, 3b, 3c) du composant électronique (1),
c) la comparaison de l'au moins une grandeur réelle (Sᵢₛₜ) avec au moins une grandeur de consigne (Sₛₒₗₗ) pour le calcul d'au moins une grandeur de correction (k), dans lequel, en ce qui concerne la grandeur de consigne (Sₛₒₗₗ), il s'agit de valeurs prédéfinies concernant la position et l'orientation des surfaces d'émission de lumière (3a, 3b, 3c) par rapport au point de référence,
d) l'équipement du support de circuit (2) avec l'au moins un composant électronique (1) en fonction de l'au moins une grandeur de correction (k).

2. Procédé selon la revendication 1, **caractérisé en ce que** la grandeur réelle (Sᵢₛₜ) et la grandeur de consigne (Sₛₒₗₗ) sont amenées à une unité de calcul numérique, ou bien sont enregistrées par celle-ci, dans laquelle la grandeur de correction (k) est calculée, dans lequel la grandeur de correction (k) est transmise en tant que signal d'information numérique à un dispositif d'équipement pour l'équipement selon l'étape d).

3. Procédé selon la revendication 1 ou 2, **caractérisé en ce que** la grandeur de correction (k) comprend au moins une grandeur vectorielle, dans lequel la direction de la grandeur vectorielle est orientée parallèlement à la surface d'équipement du support de circuit (2).

4. Procédé selon la revendication 3, **caractérisé en ce que** la grandeur de correction (k) comprend en outre une indication d'angle pour la rotation autour d'un axe de rotation (z), dans lequel l'axe de rotation est orienté orthogonalement à la surface d'équipement du support de circuit (2).

5. Procédé selon l'une des revendications 1 à 4, **caractérisé en ce que** l'au moins une grandeur réelle (Sᵢₛₜ) comprend une information caractérisant le tracé, en particulier l'inclinaison, des arêtes visibles des surfaces d'émission de lumière (3a, 3b, 3c).

6. Procédé selon l'une des revendications 1 à 4, **caractérisé en ce que** l'au moins une grandeur réelle (Sᵢₛₜ) comprend une information caractérisant un centre de gravité virtuel (S_{g}) des surfaces d'émission de lumière (3a, 3b, 3c), dans lequel le centre de gravité virtuel (S_{g}) est déterminé par détermination des centres de gravité géométriques (S₁, S₂, S₂) des surfaces d'émission de lumière (3a, 3b, 3c) individuelles en tenant compte de leurs positions réelles.

7. Procédé selon l'une des revendications 1 à 4, **caractérisé en ce que** l'au moins une grandeur réelle (Sᵢₛₜ) comprend une information caractérisant les dimensions et la position d'une surface rectangulaire fictive, dans lequel les dimensions ainsi que la position et l'orientation du rectangle fictif (R) sont sélectionnées de telle sorte que le rapport entre le chevauchement et la taille de la surface est optimisé.

8. Procédé selon l'une des revendications 1 à 7, **caractérisé en ce que** la grandeur de consigne (Sₛₒₗₗ) comprend une indication de position par rapport à un point de référence, dans lequel le point de référence est disposé au niveau du composant électronique (1) ou du support de circuit (2) du composant électronique (1).

9. Procédé selon l'une des revendications 1 à 8, **caractérisé en ce que** les surfaces d'émission de lumière (3a, 3b, 3c) sont espacées entre elles.

10. Procédé selon l'une des revendications 1 à 9, **caractérisé en ce que** l'au moins un composant électronique (1) présente une pluralité d'au moins trois, quatre, ou cinq surfaces d'émission de lumière (3a, 3b, 3c), lesquelles sont de préférence disposées en une rangée.

11. Procédé selon l'une des revendications 1 à 10, **caractérisé en ce que** le composant électronique (1) est une DEL, de préférence une DEL CMS.

12. Procédé selon l'une des revendications 1 à 11, **caractérisé en ce que**, pendant l'étape a), les surfaces d'émission de lumière (3a, 3b, 3c) sont éclairées par une source lumineuse externe.

13. Procédé selon l'une des revendications 1 à 12, **caractérisé en ce que**, pendant l'étape a), les surfaces d'émission de lumière (3a, 3b, 3c) sont excitées pour l'émission de lumière.
